# DEMANDE DE BREVET EUROPEEN

(11) **EP 1 091 627 A1**
(43) Date de publication de la demande: **11.04.2001**
(21) Numéro de dépôt: 00402711.6
(22) Date de dépôt: 03.10.2000
(51) Int. Cl.: H05K 3/34, H01L 23/498, B23K 35/02

(54) **Procédé de réalisation de connexions électriques sur la surface d'un boîtier semi-conducteur à gouttes de connexion électrique**

(30) Priorité: 05.10.1999 FR 9912380
(71) Demandeur: STMicroelectronics SA, 94250 Gentilly Cedex (FR)
(72) Inventeur: Petit, Luc, 38600 Fontaine (FR)
(74) Mandataire: Dossmann, Gérard

(57) **Abrégé**

Procédé de réalisation de connexions électriques sur la surface d'un boîtier semi-conducteur (1) contenant une puce de circuits intégrés et présentant des zones métalliques de connexion électrique (2) sur la surface du boîtier, consistant à recouvrir ces zones d'une première couche métallique (3) constituant une barrière d'anti-diffusion, à recouvrir cette première couche (3) d'une seconde couche métallique (4) d'anti-oxydation et à déposer une goutte ou bille métallique de soudure (5) sur cette seconde couche (4). Ladite goutte de soudure (5) comprend un rajout de grains métallique (6) en suspension contenant au moins l'un des métaux de ladite première couche (3), de façon à générer un précipité comprenant ces grains et au moins en partie le métal de ladite seconde couche, restant en suspension dans ladite goutte de soudure.

## Description

La présente invention concerne le domaine des boîtiers semi-conducteurs contenant une puce de circuits intégrés et plus particulièrement le domaine de la réalisation de connexions électriques sur des boîtiers semi-conducteurs à gouttes ou billes de soudure.

Dans la technique actuelle, les boîtiers semi-conducteurs présentent en surface des zones ou plots métalliques de connexion électrique qui sont en général en cuivre et sont recouvertes d'une première couche métallique d'anti-oxydation constituée généralement par du nickel ou du cobalt ou un alliage nickel-cobalt, d'une seconde couche métallique généralement en or ou en palladium et d'une goutte ou bille métallique de soudure généralement en un alliage contenant de l'étain associé à du plomb, de l'argent, et/ou du cuivre, ladite première couche constituant une barrière d'anti-diffusion pour éviter le contact direct entre la couche de cuivre et la goutte de soudure. Lesdites gouttes de soudure sont utilisées pour effectuer une liaison électrique avec un autre circuit par exemple un circuit imprimé.

Malheureusement, lorsque les boîtiers sont soumis à des contraintes mécaniques ou à des cycles de variations de température ou lorsque les boîtiers vieillissent, il arrive que certaines gouttes de soudure se détachent.

Il a pu être constaté que celà est notamment dû au fait que, lors de l'opération de soudure des gouttes de soudure sur les zones, le métal noble constituant la seconde couche précitée se dissoud dans la goutte de soudure pour donner lieu à un précipité d'étain-or ou d'étain-palladium et que, notamment avec le temps, ce précipité migre et reconstitue une couche sur la première couche précitée. Cette couche de précipité fragilise la liaison ou l'interface entre la goutte de soudure et la première couche précitée.

La présente invention a pour but de réduire ce phénomène de fragilisation afin de limiter les risques de décollement des gouttes ou billes de soudure.

Le procédé de réalisation de connexions électriques sur la surface d'un boîtier semi-conducteur contenant une puce de circuits intégrés et présentant des zones métalliques de connexions électriques sur la surface du boîtier, consiste, selon l'invention, à recouvrir ces zones d'une première couche métallique constituant une barrière d'anti-diffusion, à recouvrir cette première couche d'une seconde couche métallique d'anti-oxydation et à déposer une goutte ou bille métallique de soudure sur cette seconde couche.

Selon l'invention, ladite goutte de soudure comprend un rajout de grains métalliques en suspension contenant au moins l'un des métaux de ladite première couche, de façon à générer un précipité comprenant ces grains et au moins en partie le métal de ladite seconde couche, restant en suspension dans ladite goutte de soudure. Selon l'invention, la somme des surfaces desdits grains peut être au moins égale à la moitié de la surface de contact entre ladite goutte de soudure et ladite zone de connexion.

Selon l'invention, la somme des volumes desdits grains peut être comprise entre 0,5 et 5 pour cent du volume de ladite goutte de soudure.

Selon l'invention, ladite première couche peut avantageusement comprendre du nickel (Ni) et/ou du cobalt (Co), ladite seconde couche peut avantageusement comprendre de l'or (Au) ou du palladium (Pd) et ladite goutte de soudure peut avantageusement comprendre de l'étain (Sn) et un rajout de grains contenant du nickel (Ni) et/ou du cobalt (Co).

La présente invention va maintenant être illustrée par un exemple de réalisation de connexions électriques sur un boîtier semi-conducteur à gouttes de soudure, décrit en référence au dessin sur lequel :

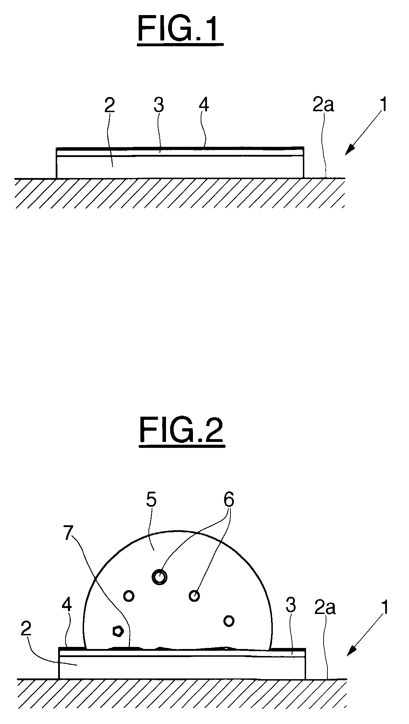

- la figure 1 représente une coupe partielle d'un boîtier avant dépôt de cette goutte de soudure ;
- et la figure 2 représente ce boîtier après soudure de cette goutte de soudure.

Disposant d'un boîtier semi-conducteur 1 préfabriqué, qui renferme une puce de circuits intégrés non représentée et qui présente une multiplicité de zones ou plots métalliques 2 réalisés sur sa surface 2a de façon à constituer une matrice de connexions électriques reliées à ladite puce de circuits intégrés, on recouvre chacune des zones métalliques 2 d'une première couche métallique 3 qui constitue une barrière d'anti-diffusion et on recouvre cette première couche 3 d'une seconde couche métallique 4 d'anti-oxydation, par exemple en or ou en palladium.

Dans la pratique, les zones métalliques sont en général en cuivre (Cu). La première couche métallique d'anti-diffusion 3 est en général constituée de nickel (Ni), de cobalt (Co) ou d'un mélange de nickel-cobalt (Ni-Co). La seconde couche d'anti-oxydation est en général composée d'or (Au) ou de palladium (Pd).

Ensuite, on dépose sur la seconde couche métallique 4 une goutte ou bille métallique de soudure 5 à base d'étain, en général un alliage d'étain et de plomb (Sn-Pb), ou d'un alliage d'étain, de plomb et d'argent (Sn-Pb-Ag) ou d'un alliage d'étain et de cuivre (Sn-Cu) ou d'un alliage d'étain et d'argent (Sn-Ag) ou d'un alliage d'étain, d'argent et de cuivre (Sn-Ag-Cu).

En outre, cette goutte métallique de soudure 5 que l'on dépose contient en suspension un rajout de grains composé d'au moins l'un des métaux constituant la première couche métallique 3, à savoir des grains de nickel (Ni) ou des grains de cobalt (Co) ou des grains de nickel-cobalt (Ni-Co).

Lors de la soudure de la goutte de soudure 5, la couche métallique 5 d'or (Au) ou de palladium (Pd) se diffuse ou se dissoud dans le volume de la goutte métallique 5 et disparaît.

Lors de cette diffusion, l'or (Au) ou le palladium (Pd) s'allie avec l'étain (Sn) pour générer des particules d'étain-or (Sn-Au) ou des particules d'étain-palladium (Sn-Pd) en suspension.

Grâce à la présence des grains de nickel 6, il se produit un précipité en suspension de nickel-étain-or (Ni-Sn-Au) ou un précipité de nickel-étain-palladium (Ni-Sn-Pd).

Ainsi, les grains de nickel piègent les particules d'or ou de palladium à l'intérieur de la masse de la goutte 5.

En fonction de la quantité de grains 6 de nickel ou de cobalt rajoutés, soit les grains de nickel ou de cobalt peuvent piéger tout l'or ou le palladium de la seconde couche 4, soit il subsiste des particules d'étain-or (Sn-Au) ou des particules d'étain-palladium (Sn-Pd).

Il convient de noter que le précipité de nickel-étain-or (Ni-Sn-Au) ou le précipité de nickel-étain-palladium (Ni-Sn-Pd) sont beaucoup plus stables que les particules d'étain-or (Sn-Au) ou des particules d'étain-palladium (Sn-Pd).

Lorsque le boîtier 1 sera ultérieurement soumis à des contraintes mécaniques ou à des cycles de variations de température ou lors de son vieillissement, le précipité de nickel-étain-or (Ni-Sn-Au) ou le précipité de nickel-étain-palladium (Ni-Sn-Pd) restera en suspension dans la goutte 5.

Par contre, s'il en subsiste, les particules d'étain-or (Sn-Au) ou des particules d'étain-palladium (Sn-Pd) auront tendance à migrer vers l'interface entre la goutte 5 et la première couche 3 et constitueront des dépôts 7. Malgré tout, ces dépôts 7 ne seront pas en mesure de recouvrir toute l'interface.

Ainsi, grâce à la présence de grains de nickel ou de cobalt dans la goutte métallique de soudure 5 mise en place, qui piègent le métal de la seconde couche 4, l'accrochage de la goutte métallique de soudure 5 sur la première couche métallique 3 n'est pas ou peu fragilisé.

La quantité de grains 6 de nickel ou de cobalt rajoutés dans la goutte de soudure 5 peut être définie de différentes manières. Dans un exemple, la somme des surfaces desdits grains 6 peut être au moins égale à la moitié de la surface de contact entre ladite goutte de soudure 5 et la première couche 3. Selon un autre exemple, la somme des volumes desdits grains 6 peut être comprise entre 0,5 et 5% du volume de ladite goutte de soudure 5.

La présente invention ne se limite pas à l'exemple ci-dessus décrit. D'autres variantes de réalisation sont possibles sans sortir du cadre défini par les revendications annexées.

## Revendications

1. Procédé de réalisation de connexions électriques sur la surface d'un boîtier semi-conducteur (1) contenant une puce de circuits intégrés et présentant des zones métalliques de connexion électrique (2) sur la surface du boîtier, consistant à recouvrir ces zones d'une première couche métallique (3) constituant une barrière d'anti-diffusion, à recouvrir cette première couche (3) d'une seconde couche métallique (4) d'anti-oxydation et à déposer une goutte ou bille métallique de soudure (5) sur cette seconde couche (4), caractérisé par le fait que ladite goutte de soudure (5) comprend un rajout de grains métallique (6) en suspension contenant au moins l'un des métaux de ladite première couche (3), de façon à générer un précipité comprenant ces grains et au moins en partie le métal de ladite seconde couche, restant en suspension dans ladite goutte de soudure.

2. Procédé selon la revendication 1, caractérisé par le fait que la somme des surfaces desdits grains est au moins égale à la moitié de la surface de contact entre ladite goutte de soudure et ladite zone de connexion.

3. Procédé selon la revendication 1, caractérisé par le fait que la somme des volumes desdits grains est comprise entre 0,5 et 5 pour cent du volume de ladite goutte de soudure.

4. Procédé selon l'une quelconque des revendications précédentes, caractérisé par le fait que ladite première couche comprend du nickel (Ni) et/ou du cobalt (Co), que ladite seconde couche comprend de l'or (Au) ou du palladium (Pd) et que ladite goutte de soudure comprend de l'étain (Sn) et un rajout de grains contenant du nickel (Ni) et/ou du cobalt (Co).
